# EUROPEAN PATENT APPLICATION

(11) **EP 4 760 855 A1**
(43) Date of publication of application: **17.06.2026**
(21) Application number: 24220131.7
(22) Date of filing: 16.12.2024
(51) Int. Cl.: H01M 10/42, H01M 10/48, B60L 3/00, G01R 31/392, B60L 58/25

(54) **THERMAL RUNAWAY EVENT IDENTIFICATION METHOD OF A BATTERY MODULE**

(71) Applicant: ABB SCHWEIZ AG, 5400 Baden (CH)
(72) Inventor: HE, Minglong, 4310 Rheinfelden (CH); LANDMANN, Daniel, 4125 Riehen (CH); KRAMER, Axel, 8057 Zürich (CH); TROENDLE, Pirmin, 79761 Waldshut-Tiengen (DE)
(74) Representative: Maiwald GmbH

(57) **Abstract**

The computer-implemented method for identifying thermal runaway events in a battery module, where multiple battery modules collectively form a Battery Energy Storage System (BESS). The method includes receiving an acoustic signal from at least one acoustic sensor positioned within the BESS. A thermal runaway event is identified if there is a sudden increase in battery noise detected in the received acoustic signal.

## Description

### FIELD OF THE INVENTION

The present disclosure relates to a system and method for detecting thermal runaway events in battery energy storage systems (BESS). Specifically, the present disclosure pertains to utilizing acoustic sensors and processing units to identify sudden battery noise increases, indicative of thermal runaway events, within battery modules of a BESS.

### BACKGROUND

In the field of BESS, it is common to employ various methods to monitor and manage the health and safety of battery modules. Known systems typically involve the use of temperature sensors, voltage sensors, and current sensors to detect anomalies that may indicate potential failures or hazardous conditions. These sensors are designed to identify issues such as overheating, overcharging, or short circuits within the battery modules. Despite these measures, thermal runaway events remain a significant concern in BESS applications.

Thermal runaway is a critical failure mode in batteries, particularly in lithium-ion batteries, where an increase in temperature can lead to a self-sustaining reaction that releases heat uncontrollably. This can result in the release of flammable gases, fires, or even explosions. Traditional monitoring systems often rely on temperature sensors to detect the onset of thermal runaway. However, these sensors may not provide sufficient early warning, as they can only detect temperature changes after the thermal runaway process has already begun. This limitation can result in delayed responses and insufficient time to take preventive actions.

In addition to temperature monitoring, some advanced systems incorporate gas sensors to detect the release of gases that may precede a thermal runaway event. While gas sensors can provide valuable information, they also have limitations. Gas sensors may not be able to detect all types of gases released during the early stages of thermal runaway, and their response time may not be fast enough to provide an effective early warning. Furthermore, the placement of gas sensors within the BESS can be challenging, as the gases may not reach the sensors quickly enough to trigger an alarm.

Another approach involves the use of electrical measurements to monitor the state of the battery modules. By analyzing voltage and current patterns, it is possible to identify irregularities that may indicate potential issues. However, this method also has its drawbacks. Electrical measurements can be influenced by various factors, such as load changes and environmental conditions, which can lead to false positives or missed detections. Additionally, this approach may not provide specific information about the location of the problem within the BESS, making it difficult to take targeted actions.

Despite the substantial advances in the field of BESS, there remains a need for improved methods to detect and identify thermal runaway events in battery modules more effectively and with greater accuracy.

It is therefore a technical problem underlying the present invention to provide a method for identifying thermal runaway events in battery modules that at least partially overcomes the disadvantages of known systems.

### SUMMARY

It is an object of this invention to provide methods that overcome one or more of the disadvantages of known systems.

According to an aspect, a method for identifying thermal runaway events in a battery module is provided, wherein multiple battery modules collectively form a BESS. The method includes receiving an acoustic signal from at least one acoustic sensor positioned within the BESS. A thermal runaway event is identified if there is a sudden increase in battery noise detected in the received acoustic signal.

According to the present disclosure, a thermal runaway event may refer to a situation where a battery experiences an uncontrolled increase in temperature, potentially leading to failure, fire, or explosion. Pre-thermal runaway event may refer to an event that happens before the positive feedback of the thermal runaway is irreversible.

According to the present disclosure, a battery module may be a unit containing at least one battery cell. The battery module may be disposed within the BESS.

According to the present disclosure, the BESS may be a large-scale system designed to store energy for later use, typically composed of numerous battery modules. At least one battery module in a vertical or horizontal arrangement may also be referred to as battery rack or rack.

According to the present disclosure, an acoustic sensor may be a device capable of detecting sound waves, and in this method, it may be used to monitor the acoustic signals emitted by the battery modules. An acoustic signal may be the sound wave data captured by the acoustic sensor.

According to the present disclosure, battery noise may refer to the general noise that is emitted from the battery module during operation. More specifically, the general noise emitted during operation from the at least one battery cell of the battery module.

According to the present disclosure, a sudden battery noise increase may be an increase of a sound level of the received acoustic signal within a specified time period by at least 0.1 decibels (dB). The time period may be an interval of 0,01 to 2 seconds, for example in a range from an interval of 0.01 s - 0.1 s, or more preferably 0.1 s to 0.5 s, or most preferably 0.5 s to 2 s. The sound level increase may optionally be at least 5 decibels. The sudden battery noise increase may optionally be an increase of the sound level of the received acoustic signal from evaluating a receiving acoustic signal compared to the previously evaluated acoustic signal.

The advantage of this method is its ability to detect early signs of thermal runaway events by monitoring acoustic signals, which can occur before visible signs such as smoke or fire. This early detection may allow for timely intervention, potentially preventing damage to the BESS and reducing risks to safety and the environment. By identifying a sudden battery noise increase, the method provides a proactive approach to managing battery safety, distinguishing it from other methods that may only detect issues after more severe symptoms have manifested.

In a preferred embodiment, the method may involve, that the acoustic signal comprises a first region, the first region is indicative of a pre-thermal runaway event, and the first region comprises: a first wide region with a frequency range of 1kHz to 20kHz, and/or at least one narrow region within a frequency range of 2kHz to 10kHz and a bandwidth of 1kHz. Optionally, the frequency range of the first wide region may be especially in 1,2kHz to 10kHz. Optionally, the frequency range of the first narrow region may be especially around a center frequency of 2,5 kHz and/or a second narrow region around a center frequency of 6kHz.

According to the present disclosure, around a center frequency and with a bandwidth may refer to a certain frequency, wherein the frequency range begins half of a bandwidth lower than the center frequency and ends half a bandwidth higher than the center frequency. This may allow identifying the pre-thermal runaway event if a sudden battery noise increase is identified in the first region of the acoustic signal.

According to the present disclosure, the acoustic signal may be indicative of a pre-thermal runaway event within the battery module. More specifically, certain frequency ranges of the acoustic signal may be indicative of a pre-thermal runaway event. The acoustic signal may be described as comprising a first region, which is indicative of a pre-thermal runaway event. This first region may be characterized by a first wide region with a frequency range of 1kHz to 20kHz, and optionally 1.2kHz to 10kHz. Additionally or alternatively, it may include at least one narrow region within a frequency range of 2kHz to 10kHz and a bandwidth of 1 kHz, with an optional preference for a first narrow region around a center frequency of 2.5kHz and/or for a second narrow region around a center frequency of 6kHz. The specific mechanisms of communication between components may involve the transmission of an acoustic signal from at least one acoustic sensor disposed in the BESS to a receiving unit that processes the signal. The new feature brought by this implementation is the detailed characterization of the acoustic signal's frequency components that may be indicative of a pre-thermal runaway event. By defining the frequency ranges and specific narrow regions within the acoustic signal, the method may enhance the ability to identify early signs of a thermal runaway event with greater precision. This detailed frequency analysis may allow for more accurate monitoring and early detection of potential thermal runaway events, thereby improving the safety and reliability of the battery module and the overall BESS. The inclusion of specific frequency ranges and narrow regions may provide a more granular approach to identifying pre-thermal runaway conditions, enabling more timely and targeted interventions to prevent the escalation of such events. This enhancement is crucial for maintaining the integrity and safety of the battery modules, as it mya allow for the detection of subtle acoustic changes that precede a thermal runaway event, facilitating proactive measures to mitigate risks.

In a preferred embodiment, the method may involve, that the acoustic signal comprises a second region. This second region may be indicative of a pending thermal runaway event. The second region may be defined by its frequency characteristics, which include a second wide region with a frequency range of 20 kHz to 1 MHz, and/or a third narrow region with a frequency range of 60 kHz to 200 kHz. Optionally, the third narrow region has a frequency range of 80 kHz to 120 kHz. This may allow identifying the pending thermal runaway event if a sudden battery noise increase is identified in the second region of the acoustic signal.

The pending thermal runaway event refers to a thermal runaway that is already progressed state (and irreversible) and is soon heading for the venting of at least one battery cell of the battery module.

By specifying these frequency ranges, the implementation may enhance the method's ability to detect early signs of a thermal runaway event, thereby providing a more precise and reliable identification process. This specificity may allow for a more targeted and accurate monitoring system, as it delineates the exact frequency ranges that are critical for identifying potential thermal runaway events. Consequently, the method may be able to differentiate more effectively between normal operational noises and those indicative of a pending thermal runaway, improving the overall safety and responsiveness of the BESS. The inclusion of these detailed frequency ranges may also imply that the acoustic sensors and the associated signal processing algorithms shall be capable of detecting and analyzing signals within these specified ranges, thereby ensuring that the system is finely tuned to recognize the early warning signs of thermal runaway. This refinement in the detection process may not only enhance the predictive capabilities of the system but may also allow for timely intervention and mitigation measures to be implemented, potentially preventing catastrophic failures and ensuring the safety and reliability of the battery modules and the BESS as a whole. The implementation, therefore, builds upon the foundational method by adding a layer of specificity and precision in the identification of pending thermal runaway events, leveraging the detailed frequency characteristics of the acoustic signal to achieve a more robust and effective monitoring solution. Hence, analyzing the acoustic signal may further allow to identify an impending thermal runaway, and based thereon, to take corresponding measures (such as warning and cutting the power of at least the affected battery module.)

In a preferred embodiment, the method may involve, that the sudden battery noise increase is identified based on integrating noise spikes of the acoustic signal over a predetermined period of time. This time period may be a minute. Tough, also other time periods of around 30 seconds and up to multiple minutes (e.g., up to 5 minutes) may be possible.

The embodiment may introduce a more refined mechanism for identifying a thermal runaway event in a battery module by specifying the method of detecting a sudden battery noise increase. This may be achieved through the integration of noise spikes over a predetermined period of time, preferably a minute.

According to the present disclosure, the noise spikes may be defined as data points of a sudden battery noise increase that exceed the amplitude of the acoustic signal by at least more than 0,1 decibels. For example, optionally: also more than 0,3 decibels, or more than 0,5 decibels, or more than 1 decibel, or more than 3 decibels, or more than 5 decibels.

This method may provide a more precise and reliable means of detecting thermal runaway events by focusing on significant deviations in the acoustic signal rather than transient or minor fluctuations. The integration of noise spikes over a set time period allows for the accumulation of data points that indicate a consistent pattern of increased battery noise, which is more indicative of a thermal runaway event than isolated spikes. Further, it may allow masking sudden battery noise that may arise on the side of operation or the environment. By setting a threshold of at least 0,1 decibels, (optionally: also more than 0,3 decibels, or more than 0,5 decibels, or more than 1 decibel, or more than 3 decibels, or more than 5 decibels) the method may ensure that only substantial increases in battery noise level are considered, reducing the likelihood of false positives caused by background noise or other non-critical disturbances. Background noise may also be referred to as ambient noise. This approach may enhance the accuracy of the thermal runaway detection process, ensuring that the system responds appropriately to genuine threats while minimizing unnecessary alarms.

The communication mechanism between components in this method may involve the transmission of acoustic signals from the acoustic sensor to the system that processes these signals. The system might be capable of analyzing the acoustic data in real-time or near-real-time to identify the noise spikes and integrate them over the specified time period. This may require a robust data processing capability and possibly a feedback loop to continuously monitor and adjust the sensitivity of the detection system based on the acoustic environment. The new feature of integrating noise spikes over time and setting a specific decibel threshold for noise spikes may bring a higher level of specificity and reliability to the thermal runaway detection process. It may allow for a more nuanced understanding of the acoustic environment within the BESS and provides a method for distinguishing between normal operational noise (background noise) and the noise associated with a thermal runaway event. This enhances the overall safety and efficiency of the battery module monitoring system by ensuring that only significant and sustained noise increases trigger an alert, thereby improving the system's ability to prevent or mitigate the consequences of thermal runaway events.

In a preferred embodiment, the method may involve that the noise spikes are data points which are exceeding the amplitude of the acoustic signal in a frequency range by at least more than 0,1 decibels. For example, optionally: also more than 0,5 decibels, or more than 1 decibel, or more than 3 decibels, or more than 5 decibels.

The implementation describes a specific mechanism for identifying noise spikes within the acoustic signal received from the battery modules in the BESS. Communication between components involves the transmission of acoustic signals from at least one acoustic sensor disposed in the BESS to a processing unit that analyzes these signals. The new feature introduced in this implementation is the definition of noise spikes as data points that are assigned certain frequency ranges. This may comprise that all noise spikes within a certain frequency range are counted together. Thereby, the way in that the noise spikes are added up may be set. The frequency range used for the noise spikes may also be referred to as slots. This frequency range used for the noise spikes may be linear, e.g., within a range of 1 to 10 (Hz/10 Hz/100Hz/kHz/10kHz/...) in two, three or four slots (three slots could be 1 to 4, 4 to 7, and 7 to 10). The spacing of the slots/frequency range could also be logarithmic.

By establishing a clear criterion for adding noise spikes within frequency ranges, the method can enhance the accuracy and reliability of detecting the specific noise patterns that are indicative of a pre- and/or pending thermal runaway event detection. This precise definition helps in distinguishing between normal operational noises and those that signify a potential safety hazard, thereby improving the overall safety and monitoring capabilities of the BESS. The inclusion of a specific decibel threshold ensures that the system can consistently and effectively identify critical events, reducing effects of background noise, reducing the likelihood of false positives, and ensuring timely intervention. This feature is particularly important in large-scale energy storage systems where the early detection of thermal runaway events can prevent catastrophic failures and enhance the longevity and performance of the battery modules. The implementation, therefore, adds a layer of specificity and robustness to the thermal runaway event identification method by incorporating a measurable and actionable parameter for noise spike detection.

In a preferred embodiment, the method is further comprising that the received acoustic signal may be processed to attenuate a background noise.

This embodiment allows to create the acoustic signal based on a differential signal. This differential signal may be the raw detected signal which might be subtracted from a background noise signal. This background noise signal could be based on a typical operation noise caused by components within the BESS (such as the noise of fans, pumps, or the like). Such a noise could be determined in advance as it usually does not deviate during operation. Hence, at least as a starting point, a typical background noise of a BESS type could be predetermined. Additionally or optionally, the background noise signal could be determined employing acoustic signal recorded in a previous period of time, where no thermal runaway event was identified. This could be a noise signal recorded two or three periods of time ago. Optionally, this previously recorded noise signal may only be used if no increase in noise (the noise signal staying below at least a certain level, e.g., below 0,1, or 0,3, or 1, or 2 or 3, or 5 decibels) was detected. Additionally or optionally, the background noise could also be attenuated by considering only a certain frequency range of the sudden battery noise frequency spectrum where the background noise level is low, and the potential sudden battery noise increase is high compared to the normal battery noise. Additionally or optionally, a neural network could be trained based on the background noise of a battery module. This neural network could also be used to identify frequency ranges of high background noise. The identified frequency ranges of high background noise may be omitted for identifying a thermal runaway event.

This method enhances the identification of a thermal runaway event by attenuating background noise. This advancement aids to prevent false positive detection and improves the thermal runaway event detection. This feature brings a higher level of precision and robustness to the thermal runaway event identification method, ensuring that the system can more effectively monitor and respond to anomalies within the battery modules. Furthermore, this embodiment may also improve cancellation of background noise. This method, therefore, not only identifies the occurrence of a thermal runaway event but also provides critical information regarding the specific location of the event within the BESS, thereby enabling more efficient and effective management of battery safety.

In a preferred embodiment, the method may involve that the acoustic sensor is disposed at each of the at least one battery modules.

The implementation introduces a new feature where an acoustic sensor is specifically disposed at each of the at least one battery modules within the BESS. Optionally, an acoustic sensor is disposed the each of the racks of the BESS. This placement of the acoustic sensor at each rack or even battery module enhances the granularity and precision of monitoring for thermal runaway events. By having an acoustic sensor at each rack or even battery module, the system can more accurately detect the source of the sudden battery noise increase, which is indicative of a thermal runaway event. This specific mechanism of communication between components involves the acoustic sensors directly receiving and transmitting acoustic signals from their respective racks or battery modules to a central processing unit or monitoring system within the BESS. The new feature brought by this implementation is the increased localization and specificity in identifying thermal runaway events. Instead of relying on a single or a few acoustic sensors to monitor the entire BESS, having an acoustic sensor at each battery rack or even battery module allows for more detailed and immediate detection of anomalies. This can lead to quicker response times and more effective mitigation measures, as the exact location of the thermal runaway event can be pinpointed with greater accuracy. Additionally, this setup can help in distinguishing between false positives and actual thermal runaway events, as the data from multiple sensors can be cross-referenced to confirm the presence of a sudden battery noise increase. This enhanced detection capability is crucial for maintaining the safety and reliability of the BESS, as thermal runaway events can lead to considerable damage and safety hazards if not promptly and accurately identified. Therefore, the implementation's feature of placing an acoustic sensor at each battery module significantly improves the overall effectiveness of the thermal runaway event identification method by providing more precise and localized monitoring.

In a preferred embodiment, the method may involve, that each of the plurality of battery modules comprises a guide unit that is configured to guide battery noise of the battery module to at least one acoustic sensor.

The implementation introduces a specific mechanism for communication between components by specifying that each of the plurality of battery modules comprises a guide unit. This guide unit is configured to guide battery noise from the battery module to at least one acoustic sensor. A guide unit may be a kind of structure that is suitable for transmitting at least one frequency of an acoustic signal that is favorable for the thermal runaway event identification. Such a guide unit may be created by attaching structural elements to the battery modules that improve the propagation via non-aerial materials (e.g. beams, bars, pipes or cones), and optionally other components of the BESS (structure, walls, cooling pipes, ducts), and further optionally also to an acoustic sensor. Optional or additionally, the guide unit could also be implemented by creating areas that increase the acoustic signal emission to the air (e.g., waveguides, holes, horns, funnels, or reflecting surfaces, such as acoustic mirrors or lenses). Thereby, it can be ensured that the acoustic sensor(s) can detect the signals accordingly, and less acoustic sensors may be required. The new feature brought by this implementation may be the inclusion of a guide unit within each battery module, which serves to direct the battery noise generated by the battery module towards the acoustic sensor. Thereby, the detection accuracy may be increased, and the amount acoustic sensors can still be reduced. This configuration may further enhance the accuracy and reliability of the thermal runaway event identification method by ensuring that the acoustic sensor receives a more focused and directed acoustic signal. The guide unit may act as a conduit or channel that funnels the battery noise specifically towards the sensor, thereby reducing the likelihood of interference from background noise and improving the sensor's ability to detect sudden battery noise increases indicative of a thermal runaway event. This targeted approach to battery noise guidance may be particularly beneficial in a BESS where multiple battery modules are present, as it helps isolate the acoustic signals from individual modules, making it easier to pinpoint the source of the battery noise. The inclusion of the guide unit may thus represent an enhancement in the method's precision and effectiveness in identifying thermal runaway events, contributing to the overall safety and operational efficiency of the BESS.

In a preferred embodiment, the method may involve that the acoustic signal is recorded with at least two acoustic sensors placed in different areas of the BESS.

This spatial distribution of acoustic sensors may enable a more precise identification of the location of a battery module experiencing a thermal runaway event. The new feature brought by this implementation may be the enhanced capability to pinpoint the exact location of the thermal runaway event within the BESS. By utilizing multiple acoustic sensors, the method may leverage the differences in the acoustic signals received from various locations to triangulate the source of the sudden battery noise increase. This triangulation process may offer accurately identifying which specific battery module is undergoing the thermal runaway event. The placement of the acoustic sensors in different areas may ensure that the system can cover a wider range and detect anomalies more effectively. This improvement may not only enhance the accuracy of thermal runaway event detection but also facilitate quicker and more targeted responses to such events, thereby potentially mitigating the risks associated with thermal runaway in battery modules. The ability to determine the precise location of the thermal runaway event may allow for more efficient intervention measures, such as cooling or isolating the affected battery module, and may improve the overall safety and reliability of the BESS. This feature may be particularly useful in large-scale energy storage systems where the early and accurate detection of thermal runaway events can prevent catastrophic failures and ensure the longevity and performance of the battery modules. By incorporating at least two acoustic sensors and utilizing their spatial data, the method may provide a robust solution for monitoring and managing the health of battery modules in a BESS, thereby offering a significant advancement over methods that rely on a single acoustic sensor or do not specify the placement of sensors within the system.

In a preferred embodiment, the method may involve, that the at least one acoustic sensor comprises a microphone and/or a transducer.

This feature may bring a more detailed and concrete understanding of the type of acoustic sensors used in the thermal runaway event identification method of a battery module within a BESS. A microphone may be typically used to detect sound waves in the air, converting them into electrical signals, which can then be analyzed for sudden battery noise increases indicative of a thermal runaway event. On the other hand, a transducer may convert various forms of energy into electrical signals, including sound waves, providing versatility in detecting acoustic signals from various sources within the BESS. The inclusion of these specific devices may ensure that the method can reliably capture and process acoustic signals to identify thermal runaway events. This specificity may enhance the robustness and reliability of the method by ensuring that the acoustic signals received are of sufficient quality and accuracy to detect sudden battery noise increases. Furthermore, the use of microphones and transducers may potentially improve the sensitivity and responsiveness of the system, enabling quicker identification of thermal runaway events, thereby enhancing the safety and operational efficiency of the BESS. By incorporating these specific types of acoustic sensors, the method may leverage the distinct advantages of each device, such as the high sensitivity of microphones to airborne sound and the versatility of transducers in detecting various forms of acoustic energy.

In a preferred embodiment, the method may involve that, upon the pre-thermal runaway event is identified, reducing the load of the battery module upon identifying a pre-thermal runaway event.

The communication mechanism between components in this context may involve the interaction between the acoustic sensor and the battery module's load management system. When the acoustic sensor detects a sudden battery noise increase, which is indicative of a potential thermal runaway event, this information may be processed to identify the pre-thermal runaway event. Subsequently, the system may communicate with the load management system of the battery module to reduce its load. This feature may enable a proactive approach to managing the battery module's condition by not only identifying the thermal runaway event but also taking immediate action to mitigate the risk. By reducing the load, the system may aim to decrease the stress on the battery module, potentially preventing the escalation of the thermal runaway event. This enhancement may improve the safety and reliability of the BESS by incorporating an additional layer of response to early warning signs, thereby enhancing the overall stability and longevity of the battery modules within the system. As the pre-thermal runaway event identification may happen at a very early stage, reducing the load of the battery modules may be sufficient to avoid the battery module entering an irreversible thermal runaway state. The method may include a critical step that directly influences the operational parameters of the battery module in response to the identified acoustic signals, ensuring that the system can react promptly to mitigate potential hazards. This integration of load reduction as a response mechanism may underscores the importance of dynamic and responsive measures in the management of BESS, particularly in scenarios where early detection of anomalies can significantly impact the safety and efficiency of the system.

According to a further aspect, a processing unit is provided which is specifically configured to execute the method outlined in any one of the preceding aspects and its embodiments (previous implementations).

According to the present disclosure, the processing unit may refer to a component of a system that performs computational tasks and processes data. In this context, it may be designed to implement the acoustic sensing method for early thermal runaway detection in BESS. This method may involve detecting acoustic signals that indicate the early stages of thermal runaway in lithium-ion batteries before the battery cell vents. The processing unit may be equipped to analyze these acoustic signals, distinguish them from other sound sources, and generate warning signals to trigger protective measures. The advantage of this configuration is that it may enhance the safety of BESS by providing an early warning system, thereby allowing sufficient time to take preventive actions and mitigate potential hazards such as fires and explosions. This early detection capability may set it apart from existing solutions that only detect abnormalities after cell venting or when burning starts.

According to a further aspect, a BESS is provided which includes at least one battery module, an acoustic sensor, and a processing unit. The acoustic sensor is designed to detect acoustic signals, which are sounds or vibrations emitted by the battery module. The processing unit is tasked with executing the method described in any one of previous implementations for early detection of thermal runaway in batteries, which is a critical safety feature. method described in any one of previous implementations.

The system may optionally comprise acoustic waveguides, which are structures that facilitate the transmission of sound waves through the battery module's housing. These waveguides may consist of hollow areas, metal connections, or specific waveguide materials. The optional inclusion of acoustic waveguides may allow for the efficient transmission of specific frequencies that are emitted by the battery module, thereby enhancing the detection capabilities of the acoustic sensor.

Optionally, the acoustic sensor itself may include a microphone or a transducer. A microphone may be a device that converts sound into an electrical signal, while a transducer is a device that converts one form of energy into another, in this case, sound into an electrical signal. The at least one of the acoustic sensors may be of the type of MEMS-based piezoelectric ultrasonic transducers, such as piezoelectric micromachined ultrasonic transducers (PMUT) or a capacitive micromachined ultrasonic transducers (CMUT)). The microphone may be positioned within the BESS and/or between the battery modules. The transducer may be attached to the module's housing, and/or a battery rack, and /or a guide unit. This configuration may ensure that the system can effectively capture the acoustic signals necessary for early detection of thermal runaway.

The advantage of this system lies in its ability to detect early signs of thermal runaway before the battery cell vents, providing a critical safety time margin. This early detection may allow for timely interventions, such as alerting first responders, triggering protective measures, isolating affected battery racks, and enhancing the cooling system's flow rate. By distinguishing early thermal runaway signals from other sound sources, the system offers a significant safety enhancement over existing solutions, which may only detect abnormalities after cell venting or when burning starts. This proactive approach may prevent catastrophic failures, reduce environmental and health impacts, and protect the company's reputation.

According to a further aspect, a computer-readable medium is provided which includes instructions. When these instructions are executed by a computer, they cause the computer to perform the method described in any one of the previous implementations. In the context of the invention, this method pertains to an acoustic sensing method for early detection of thermal runaway in BESS. The computer-readable medium may be any form of storage that can be read by a computer, such as a hard drive, USB drive, or CD-ROM. The instructions contained within this medium may be designed to enable the computer to execute the specific method steps outlined in the earlier implementations, which involve detecting acoustic signals indicative of early thermal runaway in a BESS. This early detection may allow for timely intervention to prevent fires and explosions, thereby enhancing the safety and reliability of the BESS. The advantage of this approach may be the increased safety time margin before the battery cell venting, which is a significant improvement over existing methods that only detect abnormalities after cell venting or when burning starts. This early detection capability may help in taking preventive actions such as informing first responders, triggering protective measures, isolating abnormal battery racks, and increasing the cooling system's flow rate, thereby mitigating the risks associated with thermal runaway.

According to a further aspect, a computer program product is provided which includes instructions which, when executed by a computer, enable the computer to perform the method described in any one of the previous implementations. In this context, the method may pertain to an acoustic sensing technique designed to enhance the safety of BESS by detecting early signs of thermal runaway before the battery cell vents.

According to the present disclosure the computer program product may refer to a software application or a set of instructions that can be executed by a computer to perform specific tasks. The instructions may be coded in a way that, when run on a computer, they enable the computer to carry out the method specified in previous implementations.

The advantage of this computer program product may be that it automates the process of monitoring and detecting early thermal runaway in BESS. By implementing the method through software instructions, the system may continuously and accurately monitor acoustic signals within the BESS. This early detection capability may allow for timely intervention, such as alerting first responders, triggering protective measures, isolating faulty battery racks, and increasing cooling flow rates, thereby preventing catastrophic failures like fires and explosions. This may enhance the overall safety and reliability of BESS, reduce environmental and health risks, and protect the company's reputation.

### BRIEF DESCRIPTION OF THE DRAWINGS

In the accompanying drawings,
figure 1 illustrates a schematic representation of an exemplary system;
figure 2 illustrates a flowchart illustrating a method and optional aspects according to the present disclosure;
figure 3 illustrates the sudden battery noise increase according to an embodiment of the present disclosure;
figure 4 illustrates the battery noise according to an embodiment of the present disclosure;
figure 5 illustrates the methodology of the pre-thermal runaway event identification according to an embodiment of the present disclosure;
figure 6 illustrates different battery noise levels and frequencies during different stages of operation of a battery module according to an embodiment of the present disclosure;
figure 7 illustrates different battery noise levels and frequencies during different stages of operation of a battery module according to an embodiment of the present disclosure;
figure 8 illustrates the pending thermal runaway event identification according to an embodiment of the present disclosure;
figure 9 illustrates components of an exemplary system comprising a battery noise guide according to an embodiment of the present disclosure; and
figure 10 illustrates components of an exemplary system comprising transducers according to an embodiment of the present disclosure.

### DETAILED DESCRIPTION

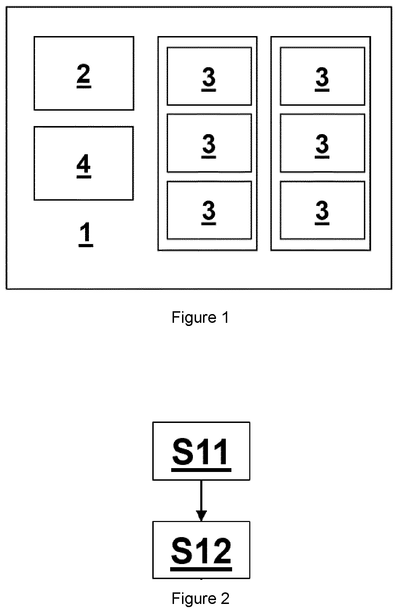

Figure 1 illustrates a system according to the present disclosure. The BESS 1 comprises a processing unit 2, multiple battery modules 3, and at least one acoustic sensor 4.

The processing unit 2 is configured for receiving, from at least one acoustic sensor 4 disposed in the BESS 1, an acoustic signal of the plurality of battery modules 3. The processing unit 2 is configured for identifying a thermal runaway event if a sudden battery noise increase is identified in the received acoustic signal.

Figure 2 illustrates is a flowchart illustrating a method according to the present disclosure and optional aspects.

A step S11 of receiving an acoustic signal of the plurality of battery modules. The acoustic signal is detected by the at least one acoustic sensor 4 that is disposed in the BESS 1.

A step S12 of identifying a thermal runaway event based on identifying a sudden battery noise increase in the received acoustic signal.

Optionally, at step S12, identifying the sudden battery noise increase is performed in a first region of the acoustic signal. A sudden battery noise increase in the first region of the acoustic signal is indicative of a pre-thermal runaway event.

Optionally or additionally, at step S12, identifying the sudden battery noise increase is performed in a second region of the acoustic signal. A sudden battery noise increase in the first region of the acoustic signal is indicative of a pending thermal runaway event.

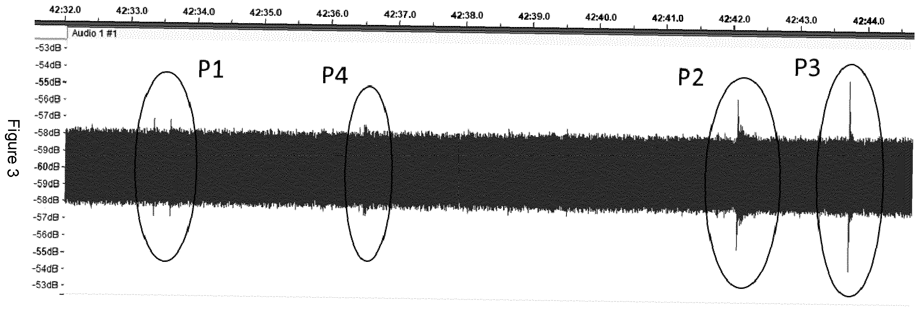

Figure 3 illustrates the sudden battery noise increase according to an embodiment of the present disclosure.

For this graph, no background noise was deducted from the raw data recorded by an acoustic sensor 4. Figure 3 illustrates the time (in min:sec) on the horizontal axis and the sound level in decibels on the vertical axis.

Figure 3 illustrated some of the possible variants of a sudden battery noise increase. In P1, two cases of a very sudden and short battery noise increase are illustrated. P2 illustrates a very sudden and steep battery noise increase that is slowly decreasing over time. P3 illustrates a very sudden and steep battery noise increase that is quickly decreasing in short time. The signal illustrated in figure 3 also illustrates multiple spots with a battery noise increase with very low levels, e.g., in P4. Also, other variants of a sudden battery noise are possible.

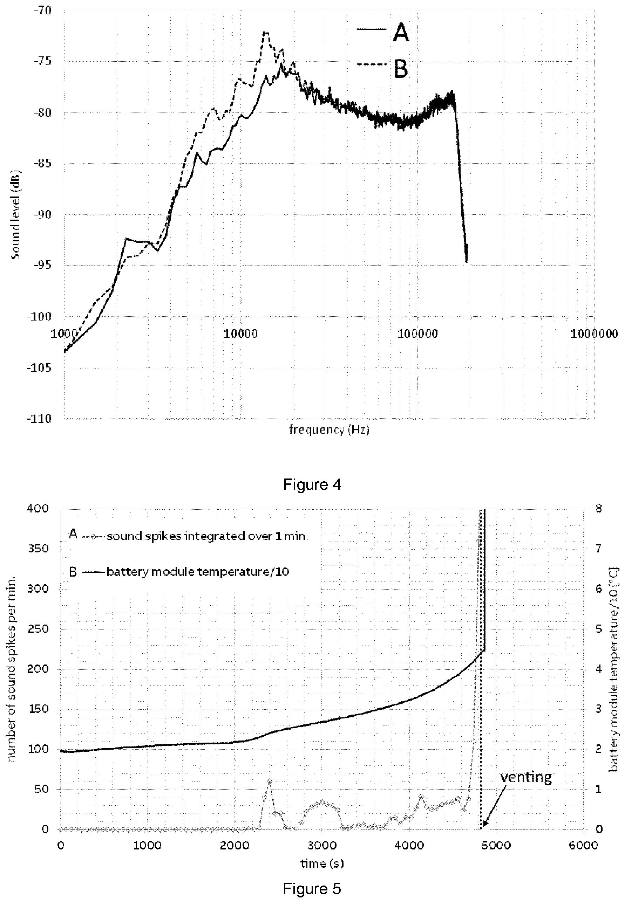

Figure 4 illustrates the battery noise according to an embodiment of the present disclosure.

For this graph, no background noise was deducted from the raw data recorded by an acoustic sensor 4. Figure 4 illustrates the frequency on the horizontal axis and the sound level in decibels on the vertical axis.

Graph A of figure 4 is indicative of the battery noise emitted during normal operation and graph B is illustrating the frequency distribution for a sudden battery sound increase. For the type of battery module 3 used for recordings of figure 4, the relevant frequency range indicative of a pre-thermal runaway is especially in the area between 4,5 kHz and 16 kHz. Within this range, the sound level of graph B is partially exceeding the sound levels of graph A by more than 5 decibels, e.g., around 7kHz, 10kHz or 13 kHz. Hence, upon considering only a sound level increase within a certain frequency range, the thermal runaway detection can be improved, and false-positive detection can be decreased. The respective frequency ranges do differ for the type of battery module 3.

Figure 5 illustrates the methodology of the pre-thermal runaway event identification.

Figure 5 illustrates a number of sound spikes of graph A on the left vertical axis. Figure 5 further illustrates a battery module temperature of graph B on the right vertical axis. The time is illustrated on the horizontal axis in seconds. Graphs A and B are both starting during normal operation mode of the battery module and illustrate the module and the sound emerging from the module over time until the venting of at least one battery cell in the battery module 3 at around 4800 seconds. Graph B shows the gradual accent of the temperature of battery module 3. This temperature would be typically determined for a battery module 3 by using one or a few temperature sensors within battery module 3 or attached to the housing of the battery housing. Attaching a temperature sensor to the housing of a battery module 3 is common practice as the housing of the battery module 3 is usually made of metal and is therefore offering a good heat transfer from the at least one battery cell inside the battery module's housing.

As indicated, the battery module's temperature rises over time, but even after the venting of at least one battery cell in the battery module 3, the temperature takes around one minute to finally incline steeply. Hence, based on the battery module temperature, an impending thermal runaway can only be detected some time after the venting, when only addressing the battery module temperature. In fact, even in experimental systems where every battery cell of a battery module 3 is equipped with a temperature sensor, the thermal runaway can only be detected seconds before the venting of a battery cell. Hence, this type of detection is not offering sufficient warning time in advance. Furthermore, this approach is too expensive and complex, as battery modules 3 can comprise hundreds of battery cells or more.

The present disclosure offers a solution that utilizes acoustics. Due to the increase of pressure and temperature in battery cells that are approaching a thermal runaway event, the battery cells start to emit battery noise. This battery noise is generated due to internal oscillation and chemical reactions. The resulting increase of battery noise is illustrated in figure 5 at around 2300 seconds. As one can see, in the time before 2300 seconds, no noise spikes are counted. This is due to attenuated external background noise. This can be utilized effortlessly for BESSs 1, as those are stationary. Therefore, the background sound is not prone to changes. Furthermore, the noise spikes (exceeding a certain threshold) are counted over a certain time period. In the case of figure 5, over a time period of one minute. This is also reducing the effect of sudden background noise increase. Furthermore, the normal noise pollution (background noise) within a BESS 1 is very linear and usually varies only minimally. Hence, the profile of this constant operational background noise can be easily determined once and then be attenuated in the raw signal of the acoustic sensor 4. Alternatively, the background noise can also be determined by a neural network. The neural network can be pre-trained and/or trained during operation. This could be performed by employing previous recordings of time periods with normal operation of the battery modules 3, or by averaging the acoustic signal over a time period of at least some minutes (e.g., at least 3 minutes, or preferably at least 5 minutes, or more preferably at least 10 minutes).

Figure 5 illustrates that the first spikes that are detected are detected around 40 minutes (first maximum of spikes at 2400 seconds) and 30 minutes (second maximum of spike at 3000 seconds) before the venting (around 4800 seconds). This allows for taking countermeasures (increase cooling and/or cut power of the respective battery module 3) that can eventually stop the thermal runaway. Upon an adequate waiting time, the battery module 3 could even continue normal operation.

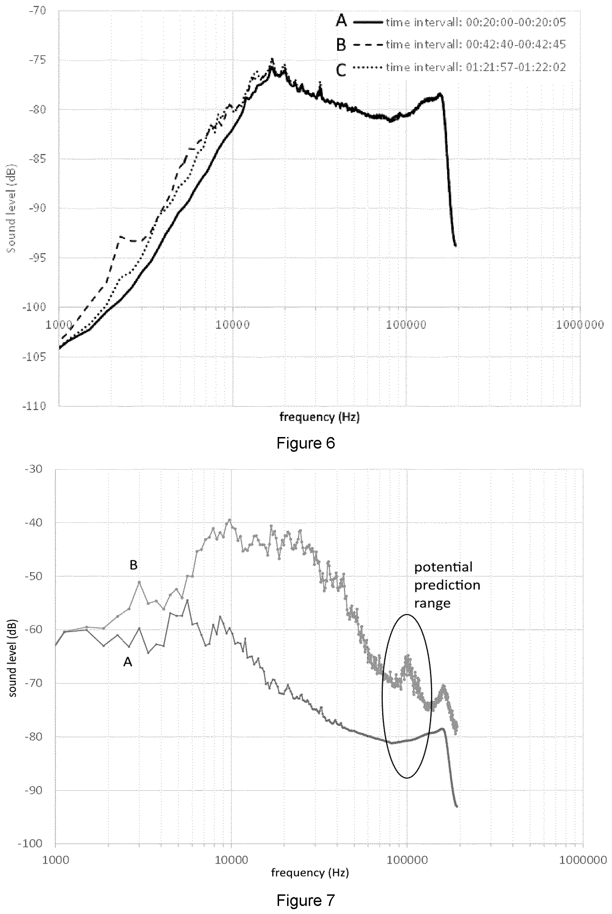

Figure 6 illustrates the raw frequency profile of a battery module 3 during different modes of operation. For this graph, no background noise was deducted from the raw data recorded by an acoustic sensor 4.

Figure 6 illustrates the frequency on the horizontal axis and the sound level in decibels on the vertical axis. Graph A illustrates the battery module 3 during normal operation. Graph B illustrates the battery module 3 during the first noise spikes indicative of the pre-thermal runaway event. Those spikes are shown in figure 5 at around 2500 seconds. Graph C illustrates the battery module 3 right before the venting takes place. When comparing the frequency range of graphs A and B, the graphs indicate strong differences of up to 7 decibels in the range of 2kHz to 10kHz. This frequency range is therefore especially significant for detecting a pre-thermal runaway event. Though, depending on the battery type and especially shape, the frequency ranges can also deviate from the illustrated example in dependence of the battery module 3. When comparing graphs C and B, the frequency profile of graph C lacks the distinctive spike at around 2kHz and is in general lower in a frequency range of 1kHz to about 8kHz. Starting from 10 kHz and onwards, graph C shows areas of increased sound levels over graph B, due to battery noise emerging from the significant swelling of the battery cells (and deformation of the battery module) due to the high internal battery cell pressure right before the venting.

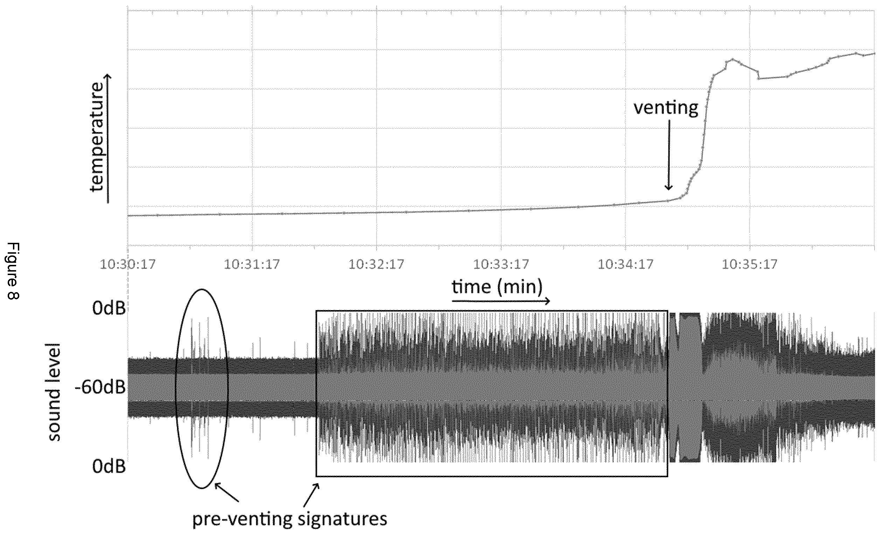

Figure 7 illustrates the raw frequency profile of a battery module 3 during different modes of operation. For this graph, no background noise was deducted from the raw data recorded by an acoustic sensor 4. Figure 7 illustrates the frequency on the horizontal axis, and the sound level in decibels on the vertical axis. Graph A illustrates the battery module 3 during normal operation. Graph B illustrates the pre-venting signatures of the battery module, also illustrated in figure 8. When comparing graphs A and B, the two graphs differ by more than 5 decibels especially in the frequency range from 6kHz to 180kHz. This frequency range offers a significant area for detecting an impending thermal runaway. Even though graphs A and B are differing in the frequency range from 6kHz to 180kHz, the course of graph B roughly relates to the course of graph A. There is however a significant exception in the frequency range of around 90kHz to 120 kHz. In this frequency range, graph B differs very distinctly from graph A, offering a frequency range for clearly identifying the pending thermal runaway. Though, depending on the battery type and especially shape, the frequency ranges can also deviate from the illustrated example in dependence of the battery module 3.

Figure 8 illustrates the sound spectrum over time of a battery module 3 that is about to vent. Figure 8 illustrates the time on the horizontal axis (in hour:min:sec), the temperature in a linear representation on the vertical axis in the upper figure and the sound level in decibels on the vertical axis in the lower part of the figure. At around time 10:31:00, and from time 10:31:30 until 10:34:30, sound spikes were recorded that are indicative of a pending thermal runaway event, before the battery cell vented at around time 10:34:30. Based on those pre-venting signatures, an impending battery venting can be identified. Though, taking countermeasures at this point in time will usually not prevent the venting as the thermal runaway is too progressed, it may at least delay the venting. Furthermore, identifying the pending thermal runaway allows to issue a warning minutes before the venting, thereby offering precious time to prepare for the venting of the at least one battery cell.

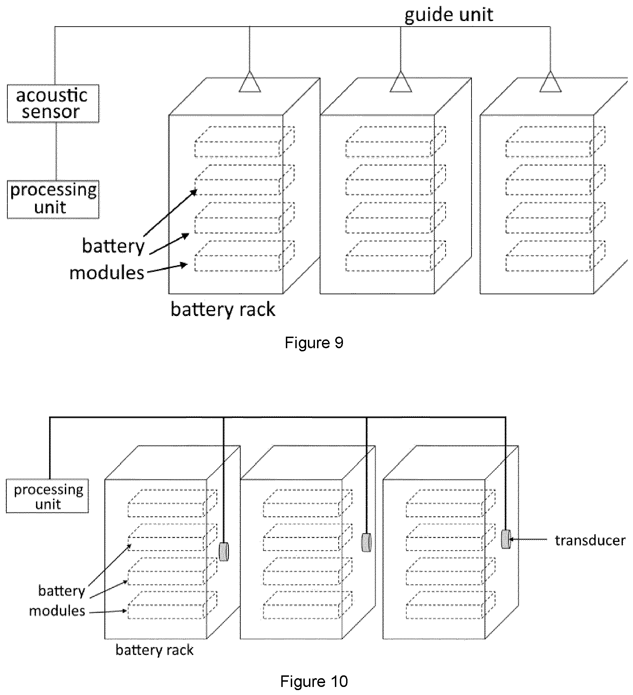

Figure 9 illustrates components of a BESS 1, including a guide unit. The battery modules 3 are illustrated to be stacked in battery racks. The battery racks are externally connected via a guide unit. The guide unit guides the acoustic signal (esp. at least a portion of one of the desired frequency ranges) to an acoustic sensor 4. The battery racks may further be equipped internally with a guide unit to enable the acoustic signal from the battery modules 3 to be transferred to the battery rack. This could happen by designing the mounting of the battery modules 3 in the battery racks in a specific way. This enables to achieve similar thermal runaway event identification results using fewer acoustic sensors 4.

Figure 10 illustrates components of a BESS 1, including a transducer. The battery modules 3 are illustrated to be stacked in battery racks. A transducer is externally connected to each of the battery racks. The battery racks may further be equipped internally with a guide unit to enable the acoustic signal from the battery modules 3 to be transferred to the battery rack. This could happen by designing the mounting of the battery modules 3 in the battery racks in a specific way. Transducers are available for a variety of frequency ranges but are usually specific to rather narrow frequency ranges. Therefore, a transducer is ideal for detecting a certain frequency range. The transducers may further be combined with at least one microphone (not shown). This approach enables to use multiple of the cheap transducers for certain frequencies, esp. for detecting the pre-thermal runaway event or the pre-venting signatures, whereas a low number of microphones are employed to detect the specific acoustic differences over a wide frequency range. This allows for arriving at a very meaningful, fail-proof and yet economic solution.

While the invention has been illustrated and described in detail in the drawings and foregoing description, such illustration and description are to be considered exemplary and not restrictive. The invention is not limited to the disclosed embodiments. In view of the foregoing description and drawings it will be evident to a person skilled in the art that various modifications may be made within the scope of the invention, as defined by the claims.

## Claims

1. An identification method of a battery module, wherein a plurality of the battery modules (3) form a Battery Energy Storage System, BESS, (1); wherein the method comprises:
receiving (S11), from at least one acoustic sensor (4) disposed in the BESS (1), an acoustic signal of the plurality of battery modules (3);
identifying (S12) a thermal runaway event if a sudden battery noise increase is identified in the received acoustic signal.

2. The method according to claim 1, wherein
the acoustic signal comprises a first region, wherein the first region is indicative of a pre-thermal runaway event, and the first region comprises:
a first wide region with a frequency range of 1kHz to 20kHz, and/or
at least one narrow region within a frequency range of 2kHz to 10kHz and a bandwidth of 1kHz.

3. The method according to any of the preceding claims, wherein
the acoustic signal comprises a second region, wherein the second region is indicative of a pending thermal runaway event, and the second region comprises:
a second wide region with a frequency range of 20 kHz to 1 MHz, and/or
a third narrow region with a frequency range of 60 kHz to 200 kHz.

4. The method according to any of the preceding claims, wherein
the sudden battery noise increase is identified based on integrating noise spikes of the acoustic signal over a predetermined period of time, wherein
the noise spikes are data points exceeding an amplitude of the acoustic signal by more than 0,1dB.

5. The method according to claim 4, wherein
the noise spikes are data points exceeding the amplitude of the acoustic signal in a frequency range by more than 0,1dB.

6. The method according to any of the preceding claims, wherein the received acoustic signal is processed to attenuate a background noise.

7. The method according to any of the preceding claims, wherein
the acoustic sensor (4) is disposed at each of the at least one battery modules (3).

8. The method according to any of the preceding claims, wherein
each of the plurality of battery modules (3) comprises a guide unit that is configured to guide battery noise of the battery module (3) to the at least one acoustic sensor (4).

9. The method according to any of the preceding claims, wherein
the acoustic signal is recorded with at least two acoustic sensors (4), wherein
the at least two acoustic sensors (4) are disposed in different areas of the BESS (1), and
the identifying a thermal runaway event comprises:
identifying, based on the acoustic signals of the disposed at least two acoustic sensors (4), a location of the battery module (3) with the thermal runaway event.

10. The method according to any of the preceding claims, wherein
the at least one acoustic sensor (4) comprises a microphone and/or a transducer.

11. The method according to any of the preceding claims, wherein
upon the pre-thermal runaway event is identified, reducing the load of the battery module (3).

12. A processing unit (2), configured to carry out the method of any one of the claims 1 to 11.

13. A system, wherein the system is a Battery Energy Storage System, BESS (1), comprising:
at least one battery module (3);
at least one acoustic sensor (4), wherein the at least one acoustic sensor (4) is configured to determine an acoustic signal; and
a processing unit (2), wherein the processing unit (2) is configured to carry out the method of any one of claims 1 to 11.

14. A computer-readable medium comprising instructions which, when executed by a computer, cause the computer to carry out the method of any one of claims 1 to 11.

15. A computer program product comprising instructions which, when the program is executed by a computer, cause the computer to carry out the method of any one of claims 1 to 11.
